# EUROPÄISCHE PATENTSCHRIFT

(11) **EP 2 464 953 B1**
(45) Veröffentlichungstag und Bekanntmachung des Hinweises auf die Patenterteilung: **28.10.2015**
(21) Anmeldenummer: 10720424.0
(22) Anmeldetag: 21.05.2010
(51) Int. Cl.: G01J 5/02, G01J 1/46, H01L 37/02, G01J 5/34

(54) **KOMPAKTER INFRAROTLICHTDETEKTOR UND VERFAHREN ZUR HERSTELLUNG DESSELBEN SOWIE EIN INFRAROTLICHTDETEKTORSYSTEM MIT DEM INFRAROTLICHTDETEKTOR**
COMPACT INFRARED LIGHT DETECTOR AND METHOD FOR PRODUCING THE SAME, AND AN INFRARED LIGHT DETECTOR SYSTEM COMPRISING THE INFRARED LIGHT DETECTOR
DÉTECTEUR INFRAROUGE COMPACT ET SON PROCÉDÉ DE FABRICATION, AINSI QUE SYSTÈME DE DÉTECTEURS INFRAROUGES DOTÉ DU DÉTECTEUR INFRAROUGE

(30) Priorität: 11.08.2009 DE 102009037111
(43) Veröffentlichungstag der Anmeldung: 20.06.2012
(73) Patentinhaber: Pyreos Ltd., EH9 3JF Edinburgh (GB)
(72) Erfinder: GIEBELER, Carsten, Edinburgh EH4 6HD (GB); CONWAY, Neil, Dunfermline Fife KY12 8YL (GB); CHAMBERLAIN, Tim, Edinburgh EH4 1HE (GB)
(74) Vertreter: Fischer, Ernst
(86) Internationale Anmeldenummer: PCT/EP2010/057050
(87) Internationale Veröffentlichungsnummer: WO 2011/018253

(56) Entgegenhaltungen:
- WO-A1-93/09414
- DE-A1- 19 525 071
- HASHIMOTO K ET AL: "Si monolithic microbolometers of ferroelectric BST thin film combined with readout FET for uncooled infrared image sensor" SENSORS AND ACTUATORS A, ELSEVIER SEQUOIA S.A., LAUSANNE, CH LNKD- DOI:10.1016/S0924-4247(00)00486-6, Bd. 88, Nr. 1, 20. Januar 2001 (2001-01-20), Seiten 10-19, XP004228208 ISSN: 0924-4247

## Beschreibung

Die Erfindung betrifft einen Infrarotlichtdetektor mit einer kompakten Bauweise und ein Infrarotlichtdetektorsystem, das den Infrarotlichtdetektor aufweist. Ferner betrifft die Erfindung ein Verfahren zur Herstellung des Infrarotlichtdetektors.

Ein Infrarotlichtdetektor zum Detektieren von Wärmestrahlung weist beispielsweise einen pyroelektrischen Sensorchip in Dünnschichtbauweise mit zwei Elektrodenschichten und einer zwischen den Elektrodenschichten angeordneten pyroelektrischen Schicht aus pyroelektrisch sensitivem Material auf. Dieses Material ist ferroelektrisches Blei-Zirkonat-Titanat (PZT). Die Elektrodenschichten bestehen aus Platin oder aus einer die Wärmestrahlung absorbierenden Chrom-Nickel-Legierung. Die Schichten sind mit einem Gasabscheideverfahren aufgebracht. Der Sensorchip ist auf einer Dünnschichtmembran angebracht, die in Sandwichbauweise aus Siliziumoxid und Siliziumnitrid hergestellt ist. Zum Auslesen, Verstärken, Verarbeiten und/oder Weiterleiten eines aufgrund von Wärmestrahlung vom Sensorchip erzeugten elektrischen Signals ist eine Ausleseelektronik vorgesehen.

Das elektrische Signal ergibt sich aus einer Ladungsverschiebung von der einen Elektrodenschicht via die pyroelektrische Schicht zu der anderen Elektrodenschicht, so dass an den Elektrodenschichten eine Differenzspannung und/oder Ladungen abgreifbar ist/sind. Die Ausleseelektronik, die beispielsweise eine elektronische Schaltung mit einem Operationsverstärker oder einem Sperrschicht-Feldeffekttransistor aufweist, hat einen hohen elektrischen Widerstand, beispielsweise von 1 GΩ bis 100 GΩ, um ein geeignet weiterverarbeitbares Signal aus dem elektrischen Signal zu generieren. Somit weist die Ausleseelektronik in der Regel einen elektrischen Widerstand und, in Kombination mit einem Operationsverstärker, zusätzlich einen Kondensator auf, wobei der elektrische Widerstand und ggf. der Kondensator zusammen mit dem Operationsverstärker bzw. dem Sperrschicht-Feldeffekttransistor als diskrete Komponenten separat von dem Infrarotlichtdetektor beispielsweise auf einer Leiterplatte montiert sind. Zum Zusammenwirken der Ausleseelektronik mit dem Infrarotlichtdetektor ist die Ausleseelektronik an den Infrarotlichtdetektor elektrisch angeschlossen.

Infrarotlichtdetektoren sind aus WO 93/09414 und DE 19 525 071 bekannt.

Dadurch, dass sowohl der Infrarotlichtdetektor als ein separates Bauteil als auch die Ausleseelektronik bestehend aus dem Operationsverstärker bzw. dem Sperrschicht-Feldeffekttransistor, dem elektrischen Widerstand und dem Kondensator als eine separate Baugruppe beispielsweise auf der Leiterplatte unterzubringen sind, ist der Platzbedarf dieser bekannten Anordnung hoch. Der hohe Platzbedarf ist insbesondere dann von Nachteil, wenn die Bauteile in einem Gehäuse untergebracht werden müssen, in dem lediglich ein limitiertes Platzangebot vorliegt. Außerdem sind der Infrarotlichtdetektor und die Ausleseelektronik jeweils in einem separaten Arbeitsschritt zu montieren. Dabei sind der Infrarotlichtdetektor und die Ausleseelektronik mittels Kabelverbindungen und Lötungen elektrisch miteinander zu verbinden. Somit ist die Montage des Infrarotlichtdetektors und der Ausleseelektronik aufwändig und kostenintensiv.

Aufgabe der Erfindung ist es, einen Infrarotlichtdetektor, ein Verfahren zur Herstellung des Infrarotlichtdetektors und ein Infrarotlichtdetektorsystem mit dem Infrarotlichtdetektor zu schaffen, wobei das Infrarotlichtdetektorsystem platzsparend und kostengünstig in der Herstellung ist.

Der erfindungsgemäße Infrarotlichtdetektor wird in den Ansprüchen 1 und 2 offenbart.

Das erfindungsgemäße Infrarotlichtdetektorsystem weist den Infrarotlichtdetektor und einen Sperrschicht-Feldeffekttransistor und/oder einen Operationsverstärker für den Signalverstärker auf, wobei der Signalverstärker an den Infrarotlichtdetektor angeschlossen ist.

Somit sind erfindungsgemäß die elektronischen Bauteile direkt auf dem Infrarotlichtdetektor integriert. Diese Integration der elektronischen Bauteile ist unmittelbar während der Herstellung des Infrarotlichtdetektors durchführbar, wodurch keine separate Herstellung von einer separaten Ausleseelektronik vorgesehen zu werden braucht. Dadurch ist die Herstellung des Infrarotlichtdetektors und des Infrarotlichtdetektorsystems kostengünstig. Ferner ist die Bauweise des Infrarotlichtdetektorsystems platzsparend, da die elektronischen Bauteile auf dem Infrarotlichtdetektor integriert angeordnet sind. Außerdem brauchen bei der Montage des Infrarotlichtdetektors die elektronischen Bauteile zusätzlich zu dem Infrarotlichtdetektor nicht als separate Teile bereitgestellt zu werden, wodurch die Handhabung des Infrarotlichtdetektors bei der Montage einfach und kostengünstig ist.

Ist beispielsweise der erfindungsgemäße Infrarotlichtdetektor für einen Infrarotgassensor vorgesehen, so ist es bekannt ein herkömmliches TO39- oder ein herkömmliches TO5-Gehäuse zum Unterbringen des Infrarotlichtdetektors zu verwenden. Wird der Infrarotgassensor zur Multigasanalyse eingesetzt, weist der Infrarotgassensor beispielsweise vier Sensorchips mit jeweils einer dazugehörigen Ausleseelektronik auf, wodurch der Infrarotgassensor einen komplizierten Aufbau hat. Dennoch können beim erfindungsgemäß ausgestalteten Infrarotgassensor die Sensorchips mit ihren dazugehörigen elektrischen Bauteilen effektiv und platzsparend in dem Gehäuse des Infrarotgassensors angeordnet sein.

Bevorzugtermaßen beinhaltet das mindestens eine elektronische Bauteil zusätzlich einen elektrischen Widerstand. Der elektrische Widerstand hat bevorzugt 100 MΩ bis 500 GΩ und der Kondensator hat bevorzugt 0,1 pF bis 100 pF.

Der elektrische Widerstand ist bevorzugt in Dünnschichtbauweise hergestellt, nämlich durch das Abscheiden einer dünnen Titanschicht, wobei das Titan bei der Herstellung des pyroelektrischen Dünnschichtelements verfügbar ist, da das PZT von drei separaten Targets von Blei, Zirkon und Titan abgeschieden wird. Der Widerstand wird in einer Sauerstoff/Argon Umgebung hergestellt, wobei der Sauerstoffgehalt bevorzugt zwischen 30% bis 80% liegt und die Filmdicke zwischen 20 bis 200 nm liegt. Der Widerstandswert liegt bevorzugt zwischen 0,1 GΩ und 100 GΩ. Der Infrarotlichtdetektor weist bevorzugt eine an der Dünnschichtmembran angebrachte Basisleitungsbahn auf, die sowohl mit dem Sensorchip als auch mit dem elektrischen Widerstand und dem Kondensator kontaktiert ist sowie an die der Signalverstärker anschließbar ist. Ferner weist bevorzugt der Infrarotlichtdetektor ein dielektrisches Dünnschichtelement, das mit seiner einen Seite auf einem der Dünnschichtmembran abgewandten Anschlussoberflächenabschnitt der Basisleitungsbahn angebracht ist und mit diesem kontaktiert ist, und eine erste Zwischenleitungsbahn auf, die mit einer anderen, der einen Seite abgewandten Seite kontaktiert ist, so dass der Kondensator von der Basisleitungsbahn, dem dielektrischen Dünnschichtelement und der ersten Zwischenleitungsbahn in Schichtbauweise gebildet ist.

Die Kapazität des Kondensators ist definiert als C = ε₀ εᵣ A/d, wobei C die Kapazität des Kondensators, A die Fläche des Überlappungsbereichs der Basisleitungsbahn mit der ersten Zwischenleitungsbahn senkrecht zur Dünnschichtmembran gesehen, d die Dicke des dielektrischen Dünnschichtelements, εᵣ die relative Dielektrizitätskonstante des dielektrischen Dünnschichtelements und ε₀ die elektrische Feldkonstante sind. Ist beispielsweise das dielektrische Dünnschichtelement aus Al₂O₃ mit einer Überlappungsfläche A von 300 µm² und einer Dicke d von 200 nm hergestellt, so ergibt sich eine Kapazität C für den Kondensator von 0,25 pF.

Der Infrarotlichtdetektor weist ferner bevorzugt eine zweite Zwischenleitungsbahn auf, mit der der elektrische Widerstand mittels elektrisch leitender Verbindung mit der Basisleitungsbahn und der ersten Zwischenleitungsbahn parallel zum Kondensator geschaltet ist. Der elektrische Widerstand kann bevorzugt von einem Dünnschichtfilm gebildet sein. Ferner weist bevorzugt der Infrarotlichtdetektor eine Basiselektrode auf, die an der Dünnschichtmembran zum Aufnehmen des pyroelektrischen Dünnschichtelements befestigt und mit diesem sowie mit der Basisleitungsbahn kontaktiert ist, so dass die Basiselektrode und die Basisleitungsbahn auf der Oberfläche der Dünnschichtmembran verlaufen. Außerdem weist bevorzugt der Infrarotlichtdetektor eine Kopfleitungsbahn und der Sensorchip eine Kopfelektrode auf, die an der der Basiselektrode abgewandten Seite des pyroelektrischen Dünnschichtelements angeordnet und mit diesem und der Kopfleitungsbahn kontaktiert ist. Die Kopfleitungsbahn wird über einen Isolator herausgeführt, der aus einer elektrisch isolierenden Metalloxidschicht gefertigt ist, bevorzugt eine Aluminiumoxidschicht, die an der Flanke des pyroelektrischen Dünnschichtelements aufgebracht ist. Bevorzugt sind die Basiselektrode, die Basisleitungsbahn und die Kopfelektrode aus Platin und die Zwischenleitungsbahnen aus Gold hergestellt.

An der Basisleitungsbahn ist bevorzugt ein Basisanschlusselement, an den Zwischenleitungsbahnen ist bevorzugt ein Zwischenanschlusselement und an der Kopfleitungsbahn ist bevorzugt ein Kopfanschlusselement angebracht, so dass zwischen dem Basisanschlusselement und dem Kopfanschlusselement eine Differenzspannung und/oder Ladungen des Sensorchips abgreifbar sind. Bevorzugtermaßen hat der elektrische Widerstand 100 MΩ bis 500 GΩ und der Kondensator 0,1 bis 100 pF.

Das Verfahren zur Herstellung des Infrarotlichtdetektors weist die Schritte auf: Bereitstellen der Dünnschichtmembran; Abscheiden von pyroelektrisch sensitivem Material auf der Dünnschichtmembran unter Ausbilden einer Dünnschicht aus dem pyroelektrisch sensitiven Material; Entfernen von überschüssigem Material von der Dünnschicht, so dass sowohl das pyroelektrische Dünnschichtelement zusammen mit dem dielektrischen Dünnschichtelement geformt werden. Es sind die weiteren Schritte bevorzugt: Abscheiden von Metall auf der Dünnschichtmembran unter Ausbilden einer Metallschicht, wobei darauffolgend das Abscheiden von dem pyroelektrisch sensitiven Material auf der Metallschicht unter Ausbilden der Dünnschicht aus dem pyroelektrisch sensitiven Material erfolgen wird; Entfernen von dem überschüssigen Material von der Metallschicht und der Dünnschicht, so dass sowohl das pyroelektrische Dünnschichtelement mit seiner Basiselektrode zusammen mit einer Basisleitungsbahn und dem dielektrischen Dünnschichtelement auf der Basisleitungsbahn geformt werden. Das pyroelektrische Dünnschichtelement und das dielektrische Dünnschichtelement sind gleichdick.

Somit wird mit dem erfindungsgemäßen Verfahren gleichzeitig sowohl das pyroelektrische Dünnschichtelement als auch das dielektrische Dünnschichtelement ausgebildet, das auf dem Anschlussoberflächenabschnitt der Basisleitungsbahn angeordnet ist. Dadurch ist das erfindungsgemäße Verfahren zur Herstellung des erfindungsgemäßen Infrarotlichtdetektors effizient und kostengünstig. Ferner weist bevorzugt das Verfahren den Schritt auf: Abscheiden eines Metalls auf dem dielektrischen Dünnschichtelement unter Ausbilden eines Kondensators und auf der Dünnschichtmembran unter Ausbilden der zweiten Zwischenleitungsbahn.

Das andere Verfahren zur Herstellung des Infrarotlichtdetektors weist die Schritte auf: Bereitstellen der Dünnschichtmembran; Abscheiden von Metall auf der Dünnschichtmembran unter Ausbilden einer Metallschicht; Abscheiden von pyroelektrisch sensitivem Material auf der Metallschicht unter Ausbilden einer Dünnschicht aus dem pyroelektrisch sensitiven Material; Entfernen von überschüssigem Material von der Dünnschicht und der Metallschicht, so dass sowohl das pyroelektrische Dünnschichtelement mit seiner Basiselektrode zusammen mit einer Basisleitungsbahn geformt werden, wobei die Basiselektrode von dem pyroelektrischen Dünnschichtelement mit einem Überstand lateral vorsteht; Abscheiden einer Metalloxidschicht unter Ausbilden eines elektrischen Isolators auf dem Überstand der Basiselektrode an der Stelle, an der eine Kopfleitungsbahn vorgesehen ist, und unter Ausbilden des dielektrischen Dünnschichtelements auf der Basisleitungsbahn, so dass das dielektrische Dünnschichtelement zusammen mit dem Isolator geformt werden. Der Isolator und das dielektrische Dünnschichtelement sind gleichdick. Als weiteren bevorzugten Schritt weist das Verfahren auf: Abscheiden eines Metalls auf dem dielektrischen Dünnschichtelement unter Ausbilden eines Kondensators und auf der Dünnschichtmembran unter Ausbilden einer Zwischenleitungsbahn. Ferner wird bevorzugt gleichzeitig das Metall derart abgeschieden, dass damit die Kopfleitungsbahn hergestellt wird.

Somit wird mit dem erfindungsgemäßen anderen Verfahren gleichzeitig sowohl der Isolator als auch das dielektrische Dünnschichtelement ausgebildet. Dadurch ist ebenfalls das andere erfindungsgemäße Verfahren zur Herstellung des erfindungsgemäßen Infrarotlichtdetektors effizient und kostengünstig. Somit sind bei der Anwendung des einen erfindungsgemäßen Verfahrens das pyroelektrische Dünnschichtelement und das dielektrische Dünnschichtelement gleichdick ausgebildet. Bei der Anwendung des anderen erfindungsgemäßen Verfahrens sind der elektrische Isolator und das dielektrische Dünnschichtelement gleichdick ausgebildet.

Im Folgenden wird ein bevorzugtes Ausführungsbeispiel eines erfindungsgemäßen Infrarotlichtdetektors und eines erfindungsgemäßen Infrarotlichtdetektorsystems anhand der beigefügten schematischen Zeichnungen erläutert. Es zeigen:
Figur 1 einen schematischen Schaltplan des Ausführungsbeispiels des erfindungsgemäßen Infrarotlichtdetektorsystems und
Figur 2 eine Draufsicht des Ausführungsbeispiels des erfindungsgemäßen Infrarotlichtdetektors.

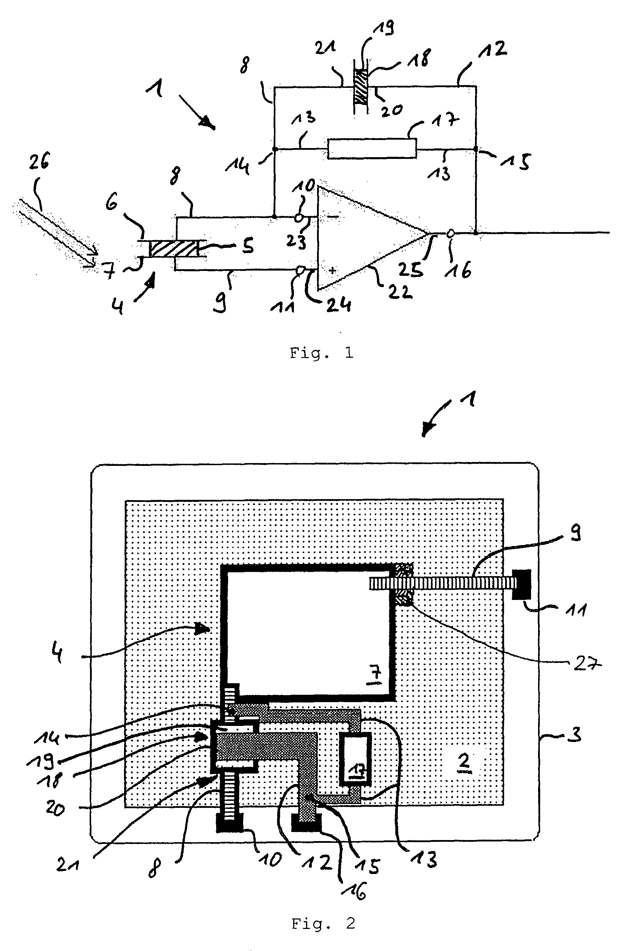

Wie es aus Figuren 1 und 2 ersichtlich ist, weist ein Infrarotlichtdetektor 1 eine Dünnschichtmembran 2 auf, die von einem Trägerrahmen 3 aufgespannt ist. Auf der Dünnschichtmembran 2 ist ein Sensorchip 4 befestigt, der von einem pyroelektrischen Dünnschichtelement 5, einer Basiselektrode 6 und einer Kopfelektrode 7 gebildet ist, wobei das pyroelektrische Dünnschichtelement 5 zwischen der Basiselektrode 6 und der Kopfelektrode 7 in Schichtbauweise angeordnet ist. Die Basiselektrode 6 ist auf der Dünnschichtmembran 2 angebracht, so dass das pyroelektrische Dünnschichtelement 5 mit der Kopfelektrode 7 von der Basiselektrode 6 auf der Dünnschichtmembran 2 aufgenommen ist. Das pyroelektrische Dünnschichtelement 5 ist mit seiner Basiselektrode 6 und seiner Kopfelektrode 7 in etwa mittig im Trägerrahmen 3 auf der Dünnschichtmembran 2 angeordnet.

Ferner ist auf der Dünnschichtmembran 2 eine Basisleitungsbahn 8 angebracht, die elektrisch leitend mit der Basiselektrode 6 verbunden ist und sich von der Basiselektrode 6 weg auf der Dünnschichtmembran 2 in Richtung zu dem Trägerrahmen 3 erstreckt. In analoger Weise ist an dem Sensorchip 4 eine Kopfleitungsbahn 9 vorgesehen, die elektrisch leitend mit der Kopfelektrode 7 verbunden ist und sich ebenfalls in Richtung zu dem Trägerrahmen 3 erstreckt, wobei die Kopfleitungsbahn 9 mit der Basisleitungsbahn 8 einen rechten Winkel einschließt. Die Basiselektrode 6 steht von dem pyroelektrischen Dünnschichtelement 5 mit einem Überstand lateral vor, wobei eine Aluminiumoxidschicht unter Ausbilden eines elektrischen Isolators 27 auf dem Überstand der Basiselektrode 6 abgeschieden ist. Die Kopfleitungsbahn 9 ist über dem Isolator 27 herausgeführt, der an der Flanke des pyroelektrischen Dünnschichtelements 5 aufgebracht ist. Mit Hilfe des Isolators 27 ist eine elektrische Isolation der Kopfleitungsbahn 9 von der Basiselektrode 6 erzielt, so dass ein elektrischer Kurzschluss von der Basiselektrode 6 und der Kopfleitungsbahn 9 unterbunden ist. Auf dem Trägerrahmen 3 ist ein Basisanschlusselement 10 angebracht, bis zu dem sich die Basisleitungsbahn 8 erstreckt und mit dem die Basisleitungsbahn 8 kontaktiert ist. Ferner ist auf dem Trägerrahmen 3 ein Kopfanschlusselement 11 angebracht, bis zu dem sich die Kopfleitungsbahn 9 erstreckt und mit dem die Kopfleitungsbahn 9 kontaktiert ist.

Die Basisleitungsbahn 8 weist einen Anschlussoberflächenabschnitt 21 auf, der von der Dünnschichtmembran 2 abgewandt angeordnet ist und bezüglich der Längsausrichtung der Basisleitungsbahn 8 mittig angesiedelt ist. Auf dem Anschlussoberflächenabschnitt 21 der Basisleitungsbahn 8 ist ein dielektrisches Dünnschichtelement 19 angeordnet, und am Anschlussoberflächenabschnitt 21 mit der Basisleitungsbahn 8 kontaktiert. Auf dem dielektrischen Dünnschichtelement 19, also auf der Seite des dielektrischen Dünnschichtelements 19, die dem Anschlussoberflächenabschnitt 21 der Basisleitungsbahn 8 abgewandt angeordnet ist, ist ein Längsende 20 einer ersten Zwischenleitungsbahn 12 befestigt und mit dem dielektrischen Dünnschichtelement 19 kontaktiert. Die von dem Längsende 20 der ersten Zwischenleitungsbahn 12 und dem Anschlussoberflächenabschnitt 21 der Basisleitungsbahn 8 in Normalrichtung der Dünnschichtmembran 2 gebildete Überlappungsfläche ist 300 µm² groß. Von dem Längsende 22 der ersten Zwischenleitungsbahn 12, dem dielektrischen Dünnschichtelement 19 und dem Anschlussoberflächenabschnitt 21 der Basisleitungsbahn 8 ist ein Kondensator 18 gebildet, der eine Kapazität von 0,25 pF hat.

Die erste Zwischenleitungsbahn 12 erstreckt sich von ihrem Längsende 20 in Richtung zu dem Trägerrahmen 3 zu einem daran befestigten Zwischenanschlusselement 16, an das die erste Zwischenleitungsbahn 12 kontaktiert ist. Zwischen dem Zwischenanschlusselement 16 und dem Längsende 20 der ersten Zwischenleitungsbahn 12 ist eine erste Leitungskreuzung 15 vorgesehen, von der kontaktiert sich eine zweite Zwischenleitungsbahn 13 erstreckt. Die zweite Zwischenleitungsbahn 13 endet schließlich an einer zweiten Leitungskreuzung 14, die die zweite Zwischenleitungsbahn 13 mit der Basisleitungsbahn 8 zwischen dem Anschlussoberflächenabschnitt 21 der Basisleitungsbahn 8 und der Basiselektrode 6 ausbildet. In der zweiten Zwischenleitungsbahn 13 ist ein elektrischer Widerstand 17 vorgesehen, der somit parallel zu dem Kondensator 18 geschaltet ist.

Auf den Sensorchip 4 einfallende Wärmestrahlung 26 erzeugt in dem pyroelektrischen Dünnschichtelement 5 eine Ladungsverschiebung, so dass zwischen der Basiselektrode 6 und der Kopfelektrode 7 eine Differenzspannung oder Ladungen ausgebildet werden. Die Stärke der Differenzspannung oder die Anzahl der Ladungen ist ein Maß für die Stärke der einfallenden Wärmestrahlung 26, so dass die Differenzspannung als ein Signal für eine Auswertung verwendbar ist. Eine wünschenswerte Verstärkung der Signalstärke ist mit einem Operationsverstärker 22 bewerkstelligbar, der einen invertierenden Eingang 23, einen nichtinvertierenden Eingang 24 und einen Ausgang 25 aufweist.

In Fig. 1 ist ein Schaltbild eines Infrarotlichtdetektorsystems mit dem Infrarotlichtdetektor 1 und dem Operationsverstärker 22 gezeigt. Der Operationsverstärker 22 ist mit seinem invertierenden Eingang 23 an das Basisanschlusselement 10, mit seinem nichtinvertierenden Eingang 24 an das Kopfanschlusselement 11 und mit seinem Ausgang 25 an das Zwischenanschlusselement 16 elektrisch leitend angeschlossen. Somit liegt die zwischen der Kopfelektrode 7 und der Basiselektrode 6 anliegende Differenzspannung zwischen dem invertierenden Eingang 23 und dem nichtinvertierenden Eingang 24 an, wobei in Rückkopplungsfunktion der Kondensator 18 und der elektrische Widerstand 17 in Parallelschaltung zwischen dem invertierenden Eingang 23 und dem Ausgang 25 geschaltet sind.

Der Kondensator 18, gebildet von dem Anschlussoberflächenabschnitt 21 der Basisleitungsbahn 8, dem dielektrischen Dünnschichtelement 19 und dem Längsende 20 der ersten Zwischenleitungsbahn 11, der elektrische Widerstand 17, der in Dünnschichtbauweise auf der Dünnschichtmembran 2 angeordnet ist, und die Zwischenleitungsbahnen 12 und 13 sind auf der Dünnschichtmembran 2 integriert angeordnet und somit integrale Bestandteile des Infrarotlichtdetektors 1. Der Operationsverstärker 22 ist mit seinen Anschlüssen 23 bis 25 an die entsprechende Anschlusselemente 10, 11 und 16 des Infrarotlichtdetektors angeschlossen und bildet somit ein vom Infrarotlichtdetektor 1 separates Bauteil, wobei der Infrarotlichtdetektor 1 ebenfalls ein separates Bauteil ist. Dadurch ist der Infrarotlichtdetektor 1 platzsparend in seiner Bauform und kostengünstig in der Herstellung.

Zur Herstellung des Infrarotlichtdetektors 1 sind die folgenden Schritte durchzuführen: Breitstellen der Dünnschichtmembran 2; Abscheiden einer Metallschicht auf der Dünnschichtmembran 2; Abscheiden eines pyroelektrisch sensitiven Materials auf der Metallschicht; Entfernen von überschüssigem Material von dem pyroelektrisch sensitivem Material und der Metallschicht, so dass sowohl die Basiselektrode 6 zusammen mit der Basisleitungsbahn 8 als auch das pyroelektrische Dünnschichtelement 5 zusammen mit dem dielektrischen Dünnschichtelement 19 geformt werden; Abscheiden einer Metalloxidschicht unter Ausbilden eines elektrischen Isolators 27 auf einem Überstand der Basiselektrode 6 an der Stelle, an der die Kopfleitungsbahn 9 vorgesehen ist; Abscheiden eines Metalls auf dem dielektrischen Dünnschichtelement 19 unter Ausbilden der ersten Zwischenleitungsbahn 12 und auf der Dünnschichtmembran 2 unter Ausbilden der zweiten Zwischenleitungsbahn 13 sowie der Kopfleitungsbahn 9, die auf dem Isolator 27 angeordnet wird. Abschließend wird die Kopfelektrode 7 durch Abscheiden von Metall auf dem dielektrischen Dünnschichtelement 5 hergestellt.

Alternativ können die folgenden Schritte zur Herstellung des Infrarotlichtdetektors 1 durchgeführt werden: Bereitstellen der Dünnschichtmembran 2 mit der Basiselektrode 6, der Basisleitungsbahn 8 und dem pyroelektrischen Dünnschichtelement 5, wobei die Basiselektrode 6 von dem pyroelektrischen Dünnschichtelement 5 mit einem Überstand vorsteht; Abscheiden einer Metalloxidschicht unter Ausbilden eines elektrischen Isolators 27 auf dem Überstand der Basiselektrode 6 an der Stelle, an der die Kopfleitungsbahn 9 vorgesehen ist, und unter Ausbilden eines dielektrischen Dünnschichtelements 19 auf der Basisleitungsbahn 8, so dass das dielektrische Dünnschichtelement 19 zusammen mit dem Isolator 27 geformt werden; Abscheiden eines Metalls auf dem Isolator 27 unter Ausbilden der Kopfleitungsbahn 9 sowie auf dem dielektrischen Dünnschichtelement 19 unter Ausbilden der ersten Zwischenleitungsbahn 12 und auf der Dünnschichtmembran 2 unter Ausbilden der zweiten Zwischenleitungsbahn 13. Abschließend wird die Kopfelektrode 7 durch Abscheiden von Metall auf dem dielektrischen Dünnschichtelement 5 hergestellt.

### Bezugszeichenliste

- 1: Infrarotlichtdetektor
- 2: Dünnschichtmembran
- 3: Trägerrahmen
- 4: Sensorchip
- 5: pyroelektrisches Dünnschichtelement
- 6: Basiselektrode
- 7: Kopfelektrode
- 8: Basisleitungsbahn
- 9: Kopfleitungsbahn
- 10: Basisanschlusselement
- 11: Kopfanschlusselement
- 12: erste Zwischenleitungsbahn
- 13: zweite Zwischenleitungsbahn
- 14: zweites Leitungskreuzung
- 15: erstes Leitungskreuzung
- 16: Zwischenanschlusselement
- 17: elektrischer Widerstand
- 18: Kondensator
- 19: dielektrisches Dünnschichtelement
- 20: Längsende der ersten Zwischenleitungsbahn
- 21: Anschlussoberflächenabschnitt der Basisleitungsbahn
- 22: Operationsverstärker
- 23: invertierender Eingang
- 24: nichtinvertierender Eingang
- 25: Ausgang
- 26: einfallendes Licht
- 27: Isolator

## Patentansprüche

1. Infrarotlichtdetektor mit einem Sensorchip (4), der ein aus einem pyroelektrisch sensitiven Material hergestelltes Dünnschichtelement. (5) aufweist mit einem elektrischen Isolator (27), einer Ausleseelektronik, welche mindestens ein elektronisches Bauteil (17, 18) in Dünnschichtbauweise und Anschlusselemente (10,16) aufweist, und einer Dünnschichtmembran (2), auf der der Sensorchip (4) und das elektronische Bauteil (17, 18) nebeneinander liegend derart integriert angebaut sind, dass das elektronische Bauteil (17, 18) mit dem Dünnschichtelement (5) elektrisch leitend gekoppelt ist und an das elektronische Bauteil (17, 18) via die Anschlusselemente (10, 16) ein Signalverstärker (22) anschließbar ist, mit dem unter Zusammenwirken mit dem elektronischen Bauteil (17, 18) ein vom Sensorchip (4) abgegebenes elektrisches Signal verstärkbar ist, wobei das mindestens eine elektronische Bauteil ein Kondensator (18) mit einem dielektrischen Dünnschichtelement (19) ist, wobei das pyroelektrische Dünnschichtelement (5) und das dielektrische Dünnschichtelement (19) gleichdick aus dem selben Material hergestellt sind.

2. Infrarotlichtdetektor mit einem Sensorchip (4), der ein aus einem pyroelektrisch sensitiven Material hergestelltes Dünnschichtelement. (5) aufweist mit einem elektrischen Isolator (27), einer Ausleseelektronik, welche mindestens ein elektronisches Bauteil (17, 18) in Dünnschichtbauweise und Anschlusselemente (10,16) aufweist, und einer Dünnschichtmembran (2), auf der der Sensorchip (4) und das elektronische Bauteil (17, 18) nebeneinander liegend derart integriert angebaut sind, dass das elektronische Bauteil (17, 18) mit dem Dünnschichtelement (5) elektrisch leitend gekoppelt ist und an das elektronische Bauteil (17, 18) via die Anschlusselemente (10, 16) ein Signalverstärker (22) anschließbar ist, mit dem unter Zusammenwirken mit dem elektronischen Bauteil (17, 18) ein vom Sensorchip (4) abgegebenes elektrisches Signal verstärkbar ist, wobei das dielektrische Dünnschichtelement (19) aus dem Material des Isolators (27), das ein Metalloxid ist, insbesondere Aluminiumoxid, hergestellt ist, wobei der Isolator (27) und das dielektrische Dünnschichtelement (19) gleichdick sind.

3. Infrarotlichtdetektor gemäß Anspruch 1 order 2, wobei das mindestens eine elektronische Bauteil (17, 18) zusätzlich einen elektrischen Widerstand (17) aufweist.

4. Infrarotlichtdetektor gemäß Anspruch 3, wobei der elektrische Widerstand (17) 100 MΩ bis 500 GΩ und der Kondensator (18) 0,1 pF bis 100 pF haben.

5. Infrarotlichtdetektorsystem mit einem Infrarotlichtdetektor gemäß einem der Ansprüche 1 bis 4 und einem Sperrschicht-Feldeffekttransistor und/oder einem Operationsverstärker (22) für den Signalverstärker (22), wobei der Signalverstärker (22) an den Infrarotlichtdetektor (1) angeschlossen ist.

6. Verfahren zur Herstellung eines Infrarotlichtdetektors gemäß einem der Ansprüche 1 oder 3 bis 5, mit den Schritten:
Bereitstellen der Dünnschichtmembran (2);
Abscheiden von pyroelektrisch sensitivem Material auf der Dünnschichtmembran (2) unter Ausbilden einer Dünnschicht aus dem pyroelektrisch sensitiven Material;
Entfernen von überschüssigem Material von der Dünnschicht, so dass das pyroelektrische Dünnschichtelement (5) zusammen mit dem dielektrischen Dünnschichtelement (19) geformt wird, wobei das pyroelektrische Dünnschichtelement (5) und das dielektrische Dünnschichtelement (19) gleichdick und aus dem selben Material sind.

7. Verfahren gemäß Anspruch 6, mit den Schritten:
Abscheiden von Metall auf der Dünnschichtmembran (2) unter Ausbilden einer Metallschicht (6, 8);
Entfernen von dem überschüssigen Material, so dass sowohl das pyroelektrische Dünnschichtelement (5) mit seiner Basiselektrode (6) zusammen mit einer Basisleitungsbahn (8) und dem dielektrischen Dünnschichtelement (19) auf der Basisleitungsbahn (8) geformt werden.

8. Verfahren zur Herstellung eines Infrarotlichtdetektors gemäß einem der Ansprüche 2 bis 5, mit den Schritten:
Bereitstellen der Dünnschichtmembran (2);
Abscheiden von Metall auf der Dünnschichtmembran (2) unter Ausbilden einer Metallschicht;
Abscheiden von pyroelektrisch sensitivem Material auf der Metallschicht unter Ausbilden einer Dünnschicht aus dem pyroelektrisch sensitiven Material;
Entfernen von überschüssigem Material von der Dünnschicht und der Metallschicht, so dass sowohl das pyroelektrische Dünnschichtelement (5) mit seiner Basiselektrode (6) zusammen mit einer Basisleitungsbahn (8) geformt werden, wobei die Basiselektrode (6) von dem pyroelektrischen Dünnschichtelement (5) mit einem Überstand lateral vorsteht;
Abscheiden einer Metalloxidschicht unter Ausbilden eines elektrischen Isolators (27) auf dem Überstand der Basiselektrode (6) an der Stelle, an der eine Kopfleitungsbahn (9) vorgesehen ist, und unter Ausbilden des dielektrischen Dünnschichtelements (19) auf der Basisleitungsbahn (8), so dass das dielektrische Dünnschichtelement (19) zusammen mit dem Isolator (27) geformt wird,
wobei der Isolator (27) und das dielektrische Dünnschichtelement (19) gleichdick und aus dem selben Material sind.

9. Verfahren gemäß einem der Ansprüche 6 bis 8, mit dem Schritt: Abscheiden eines Metalls auf dem dielektrischen Dünnschichtelement (19) unter Ausbilden eines Kondensators (18) und auf der Dünnschichtmembran unter Ausbilden einer Zwischenleitungsbahn (13).

## Claims

1. Infrared light detector with a sensor chip (4) that comprises a thin layer element (5) made out of a pyroelectric sensitive material, wherein the thin layer element (5) has an electrical insulator (27), wherein the sensor chip (4) comprises a readout electronics which comprises at least one electronic member (17, 18) in thin layer design and connection elements (10, 16), and a thin layer membrane (2) on which the sensor chip (4) and the electronic member (17, 18) are attached integratedly lying next to each other such that the electronic member (17, 18) is coupled electrically conductive with the thin layer element (5) and a signal amplifier (22) can be connected to the electrical member (17, 18) via the connection elements (10, 16), wherein an electrical signal emitted by the sensor chip (4) can be amplified by the signal amplifier (22) under cooperation with the electronic member (17, 18), wherein the at least one electronic member is a condenser (18) with a dielectric thin layer element (19), wherein the pyroelectric thin layer element (5) and the dielectric thin layer element (19) are made equally thick out the same material.

2. Infrared light detector with a sensor chip (4) that comprises a thin layer element (5) made out of a pyroelectric sensitive material, wherein the thin layer element (5) has an electrical insulator (27), wherein the sensor chip (4) comprises a readout electronics which comprises at least one electronic member (17, 18) in thin layer design and connection elements (10, 16), and a thin layer membrane (2) on which the sensor chip (4) and the electronic member (17, 18) are attached integratedly lying next to each other such that the electronic member (17, 18) is coupled electrically conductive with the thin layer element (5) and a signal amplifier (22) can be connected to the electrical member (17, 18) via the connection elements (10, 16), wherein an electrical signal emitted by the sensor chip (4) can be amplified by the signal amplifier (22) under cooperation with the electronic member (17, 18), wherein the at least one electronic member is a condenser (18) with a dielectric thin layer element (19), wherein the dielectric thin layer element (19) is made out of the material of the insulator (27) that is a metal oxide, in particular aluminium oxide, wherein the insulator (27) and the dielectric thin layer element (19) are equally thick.

3. Infrared light detector according to claim 1 or 2, wherein the at least one electronic member (17, 18) comprises additionally an electrical resistance (17).

4. Infrared light detector according to claim 3, wherein the electrical resistance (17) has 100 MΩ to 500 GΩ and the condenser (18) has 0.1 pF to 100 pF.

5. Infrared light detector system with an infrared light detector according to any one of claims 1 to 4 and a barrier layer field effect transistor and/or an operational amplifier (22) for the signal amplifier (22), wherein the signal amplifier (22) is connected to the infrared light detector (1).

6. Method for making an infrared light detector according to any one of claims 1 or 3 to 5, with the steps:
Providing the thin layer membrane (2);
Depositing of pyroelectric sensitive material on the thin layer membrane (2) under forming a thin layer out of the pyroelectric sensitive material;
Removing of surplus material from the thin layer so that the pyroelectric thin layer element (5) is formed together with the dielectric thin layer element (19), wherein the pyroelectric thin layer element (5) and the dielectric thin layer element (19) are equally thick and out of the same material.

7. Method according to claim 6, with the steps:
Depositing of metal on the thin layer membrane (2) under forming of a metal layer (6, 8);
Removing of surplus material so that the pyroelectric thin layer element (5) with its base electrode (6) together with a base conductive track (8) and the dielectric thin layer element (19) are formed on the base conductive track (8).

8. Method for making an infrared light detector according to any one of claims 2 to 5, with the steps;
Providing the thin layer membrane (2);
Depositing of metal on the thin layer membrane (2) under forming of a metal layer;
Depositing of pyroelectric sensitive material on the metal layer under forming of a thin layer out of the pyroelectric sensitive material;
Removing of surplus material from the thin layer and the metal layer so that the pyroelectric thin layer element (5) with its base electrode (6) together with a base conductive track (8) are formed, wherein the base electrode (6) laterally protrudes from the pyroelectric thin layer element (5) with a protrusion;
Depositing of a metal oxide layer under forming of an electrical insulator (27) on the protrusion of the base electrode (6) on the position on which a top conductive track (9) is provided, and under forming the dielectric thin layer element (19) on the base conductive track (8) so that the dielectric thin layer element (19) is formed together with the insulator (27), wherein the insulator (27) and the dielectric thin layer element (19) are equally thick and out of the same material.

9. Method according to any one of claims 6 to 8, with the step: Depositing of a metal on the dielectric thin layer element (19) under forming of a condenser (18) and on the thin layer membrane under forming of an intermediate conductive track (13).

## Revendications

1. Détecteur de lumière infrarouge ayant une puce (4) de détection comportant un élément à couche mince (5) fait d'un matériau pyroélectriquement sensible avec un isolant électrique (27), une électronique de lecture qui comprend au moins un composant électronique (17, 18) construit en couche mince et des éléments de raccordement (10, 16) ; et une membrane (2) à couche mince, par laquelle la puce (4) de détection et le composant électronique (17, 18) sont adjacents et montés de façon intégrée de telle sorte que le composant électronique (17, 18) soit relié électriquement à l'élément à couche mince (5), et un amplificateur de signal (22) apte à être raccordé au composant électronique (17, 18) par l'intermédiaire des éléments de raccordement (10, 16) pouvant amplifier un signal électrique émis par la puce (4) de détection en interaction avec le composant électronique (17, 18), ledit au moins un composant électronique étant un condensateur (18) avec un élément diélectrique (19) à couche mince, l'élément à couche mince pyroélectrique (5) et l'élément à couche mince diélectrique (19) étant fabriqués à partir du même matériau et avec la même épaisseur.

2. Détecteur de lumière infrarouge ayant une puce (4) de détection comportant un élément à couche mince (5) fait d'un matériau pyroélectriquement sensible avec un isolant électrique (27), une électronique de lecture raccordée à au moins un composant électronique (17, 18) construit en couche mince et des éléments de raccordement (10, 16) ; et une membrane (2) à couche mince, par laquelle la puce (4) de détection et le composant électronique (17, 18) sont adjacents et montés de façon intégrée de telle sorte que le composant électronique (17, 18) soit relié électriquement à l'élément à couche mince (5), un amplificateur de signal (22) apte à être raccordé au composant électronique (17, 18) par l'intermédiaire des éléments de raccordement (10, 16) pouvant amplifier un signal électrique émis par la puce (4) de détection en interaction avec le composant électronique (17, 18), ledit au moins un composant électronique étant un condensateur (18) avec un élément diélectrique à couche mince (19), l'élément à couche mince diélectrique (19) étant réalisé dans le matériau de l'isolant (27), qui est un oxyde métallique, en particulier de l'oxyde d'aluminium, l'isolant (27) et l'élément à couche mince diélectrique (19) ayant la même épaisseur.

3. Détecteur de lumière infrarouge selon la revendication 1 ou la revendication 2, dans lequel au moins un composant électronique (17, 18) définit en outre une résistance électrique (17).

4. Détecteur de lumière infrarouge selon la revendication 3, dans lequel la résistance électrique (17) est étalonnée entre 100 MΩ et 500 GΩ et le condensateur (18) entre 0,1 pF et 100 pF.

5. Système de détection de lumière infrarouge ayant un détecteur de lumière infrarouge selon l'une quelconque des revendications 1 à 4 et un transistor à effet de champ, et / ou un amplificateur opérationnel (22) pour l'amplificateur de signal (22), l'amplificateur de signal (22) étant raccordé au détecteur de lumière infrarouge (1).

6. Procédé de fabrication d'un détecteur de lumière infrarouge selon l'une quelconque des revendications 2 à 5, comprenant les étapes consistant à :
préparer une membrane à couche mince (2) ;
déposer un matériau pyroélectriquement sensible sur la membrane à couche mince (2) pour former un film mince de matériau pyroélectriquement sensible ;
enlever de la couche mince le matériau en excès, de sorte que l'élément à couche mince pyroélectrique (5) est formé avec l'élément diélectrique à couche mince (19), l'élément pyroélectrique à couche mince (5) et l'élément diélectrique à couche mince (19) étant faits de la même matière et ayant la même épaisseur.

7. Procédé selon la revendication 6, comprenant les étapes consistant à :
déposer un métal sur la membrane à couche mince (2) pour former une couche métallique (6, 8) ;
éliminer le matériau en excès, de sorte qu'à la fois l'élément à couche mince pyroélectrique (5) et son électrode de base (6), de même qu'une piste conductrice de base (8) et l'élément à couche mince diélectrique (19), sont formés sur la piste conductrice de base (8).

8. Procédé de fabrication d'un détecteur de lumière infrarouge selon l'une des revendications 2 à 5, comprenant les étapes consistant à :
préparer une membrane à couche mince (2) ;
déposer un métal sur la membrane à couche mince (2) pour former une couche de métal ;
déposer un matériau pyroélectriquement sensible sur la couche de métal pour former un film mince de matériau pyroélectriquement sensible ;
enlever de la couche mince le matériau en excès ainsi que la couche de métal, de sorte qu'à la fois l'élément à couche mince pyroélectrique (5) avec son électrode de base (6), de même qu'une piste conductrice de base (8) sont formés, l'électrode de base (6) de l'élément à couche mince pyroélectrique (5) ayant une saillie débordant latéralement ;
déposer une couche d'oxyde de métal pour former un isolant électrique (27) sur la saillie de l'électrode de base (6) à l'endroit où une piste de conduction de tête (9) est prévue, et pour former l'élément à couche mince diélectrique (19) sur la piste de conduction de base (8), de sorte que l'élément à couche mince diélectrique (19) soit formé avec l'isolant (27),
l'isolant (27) et l'élément diélectrique à couche mince (19) étant faits de la même matière et ayant la même épaisseur.

9. Procédé selon l'une quelconque des revendications 6 à 8, comprenant l'étape consistant à : déposer un métal sur l'élément diélectrique à couche mince (19) pour former un condensateur (18) et sur la membrane à couche mince pour former une piste de conduction intermédiaire (13).
